# EUROPÄISCHE PATENTSCHRIFT

(11) **EP 1 344 316 B1**
(45) Veröffentlichungstag und Bekanntmachung des Hinweises auf die Patenterteilung: **20.08.2008**
(21) Anmeldenummer: 00983440.9
(22) Anmeldetag: 20.12.2000
(51) Int. Cl.: H03K 3/537, H01T 1/00

(54) **TRAGENDE KAMINSTRUKTUR FÜR ELEKTRISCHEN IMPULSGENERATOR**
SUPPORTING FLUE STRUCTURE FOR AN ELECTRICAL PULSE GENERATOR
STRUCTURE DE CHEMINEE PORTEUSE POUR GENERATEUR D'IMPULSIONS ELECTRIQUES

(43) Veröffentlichungstag der Anmeldung: 17.09.2003
(73) Patentinhaber: Haefely Test AG, 4028 Basel (CH)
(72) Erfinder: LOPPACHER, Matthias, CH-4054 Basel (CH)
(74) Vertreter: Blum, Rudolf Emil
(86) Internationale Anmeldenummer: PCT/IB2000/001945
(87) Internationale Veröffentlichungsnummer: WO 2002/051007

(56) Entgegenhaltungen:
- DE-A- 3 516 153
- DE-B- 1 049 495
- US-A- 3 248 574

## Beschreibung

### TECHNISCHES GEBIET

Die Erfindung bezieht sich auf das Gebiet der Hochspannungstechnik. Sie betrifft einen elektrischen Impulsgenerator gemäss Oberbegriff des unabhängigen Anspruchs.

### STAND DER TECHNIK

In einem Marx'schen Impulsspannungsgenerator sind mehrere Generatorstufen von einem Traggerüst turmförmig übereinander gehaltert. Das Traggerüst ist typischerweise aus einzelnen Isolationsrohren aus Hartpapier oder glasfaserverstärktem Kunststoff zusammengesetzt und weist gegebenenfalls zur Verbesserung der mechanischen Stabilität Verstrebungen, einen Stahlrahmen, Zwischenplattformen, seitliche Abspannungen mit Glasfaserkabel o. ä. auf. Die Generatorstufen werden in einer Parallelschaltung aufgeladen und in einer Serieschaltung durch ein Schaltorgan, im allgemeinen eine Schaltfunkenstrecke, entladen. Insbesondere bei höheren Stossspannungen, zu deren Erzeugung eine Mehrzahl von Schaltorganen nötig ist, muss bei Verwendung von Kugelfunkenstrecken in freier Luft mit spontanen, ungewollten Schaltvorgängen gerechnet werden. Eine Herabsetzung der Durchschlagsspannung und eine Selbstzündung der Funkenstrecken kann durch Verunreinigungen in der Luft, beispielsweise aufgrund von Staubablagerungen, Schwebeteilchen, Abbrand oder Ozonbildung bei vorherigen Entladevorgängen, verursacht werden. Dieses Problem wurde bisher durch gemeinsame oder individuelle Kapselung der Funkenstrecken und Durchströmen der Kapselung mit gefilterter Luft gelöst.

Aus der Patentschrift DE 10 49 495 B ist ein mehrstufiger elektrischer Stossspannungs-Prüfgenerator bekannt, der einen Isoliermantel umfasst, welcher einen elliptischen oder kreisförmigen Querschnitt aufweist. Im Inneren des Isoliermantels sind ein Stosskondensator, eine Stossfunkenstrecke oder Schaltfunkenstrecke, Ladewiderstände und Entladewiderstände angeordnet.

Aus der Patentanmeldung DE 35 16 153 A1 ist ein Stossspannungsgenerator bekannt, der aus einer oder mehreren Stufen besteht, deren Wandungen in der Draufsicht ein gleichseitiges Drei- oder Mehreck bilden. Die die Schaltung beeinflussenden elektronischen Bauelemente sind leicht austauschbar an den Aussenseiten der Wandungen angeordnet. Bei den Bauelementen handelt es sich um Widerstände, wie Lade-, Entlade- oder Dämpfungswiderstände, einen Stosskondensator und eine Schaltfunkenstrecke.

Eine gemeinsame Kapselung wird beispielsweise von der Firma Highvolt in Dresden dadurch realisiert, dass ein separater, seitlich von dem Traggerüst angeordneter Kamin geschaffen wird, der die vertikal übereinander angeordneten Funkenstrecken umhüllt und am unteren Ende eine Lufteintrittsöffnung mit einem Gebläse und am oberen Ende eine Luftaustrittsöffnung aufweist. Der Kamin kann als Isolationsrohr gegebenenfalls mit Sichtfenstern auf die Funkenstrecken ausgeführt sein. Nachteilig ist der konstruktive und kostenmässige Zusatzaufwand. Einerseits muss das Traggerüst des Stossgenerators zur zusätzlichen Halterung des Kamins ausgelegt sein. Andererseits müssen die Funkenstrecken relativ separat von den übrigen Komponenten des Stossgenerators angeordnet sein, um hinreichende Isolationsabstände zwischen der Kaminwand und den Funkenstrecken zu gewährleisten. Die umschlossene Fläche des Zündstromkreises wird dadurch vergrössert und das Schaltverhalten durch eine erhöhte Selbstinduktivität verschlechtert.

Eine individuelle Kapselung jeder einzelnen Funkenstrecke wird beispielsweise von der Firma Passoni & Villa realisiert. Jede Kapelsung wird separat mit gefilterter Luft versorgt und der Luftaustausch durch Undichtigkeit erreicht. Der Raumbedarf für die Kapselung in jeder Generatorstufe sowie die Druckluftversorgungsleitungen bedingen wiederum einen erheblichen Zusatzaufwand.

### DARSTELLUNG DER ERFINDUNG

Es ist Aufgabe der Erfindung, einen verbesserten elektrischen Impulsgenerator anzugeben, bei dem unbeabsichtigte Selbstzündungen von Funkenstrecken mit geringem Zusatzaufwand unterbunden werden. Diese Aufgabe wird durch die Merkmale des unabhängigen Anspruchs gelöst.

Die erfindungsgemässe Lösung besteht in einem elektrischen Impulsgenerator, der insbesondere zur Erzeugung hoher Impulsspannungen oder Impulsströme geeignet ist, der ein Traggerüst für mindestens eine aufladbare Generatorstufe umfasst, die eine Schaltfunkenstrecke zur Erzeugung elektrischer Durchschläge in einem gasförmigen Medium und weitere elektrische Komponenten zum Aufladen und/oder Entladen der Generatorstufe aufweist, wobei die Schaltfunkenstrecke in einem Kamin mit einem vorgebbaren Gasaustausch zur Regulierung und/oder Konstanthaltung der Durchschlagsfestigkeit des gasförmigen Mediums angeordnet ist, wobei ferner der Kamin als eine Tragkonstruktion ausgelegt ist und die Tragkonstruktion eine tragende Funktion für die Schaltfunkenstrecke und für mindestens eine der elektrischen Komponenten der mindestens einen aufladbaren Generatorstufe hat. Durch die Integration tragender Funktionen in den Kamin kann der bauliche Aufwand für ein herkömmliches Traggerüst reduziert oder eliminiert werden. Dadurch sind erhebliche Kosteneinsparungen möglich.

In einem Ausführungsbeispiel hat der Kamin eine tragende Funktion für mindestens einen Stosskondensator und/oder für mindestens einen Seriewiderstand, Parallelwiderstand, Ladewiderstand und/oder Potentialwiderstand der mindestens einen aufladbaren Generatorstufe. Insbesondere bildet der Kamin das Traggerüst für alle Generatorstufen des Impulsgenerators.

In einem anderen Ausführungsbeispiel ist der Kamin ein Isolationsrohr mit einem polygonalen oder runden Querschnitt und sind an Seitenwänden des Isolationsrohrs die elektrischen Komponenten jeder Generatorstufe, insbesondere ein Stosskondensator, ein Seriewiderstand und ein Parallelwiderstand, befestigbar. Auf diese Weise wird ein innenliegender Kamin geschaffen und eine sehr einfache und kompakte Bauweise für den Impulsgenerator realisiert.

In einem weiteren Ausführungsbeispiel weist das Isolationsrohr eine kleine Querschnittsfläche zur Schaffung eines niederinduktiven Zündstromkreises mit einer kleinen umschlossene Fläche auf. Durch die integrierte Kamin- und Traggerüststruktur kann tatsächlich die Induktivität des Zündstromkreises auf bisher für gekapselte Impulsgeneratoren unerreichbar tiefe Werte gesenkt werden und das elektrische Schaltverhalten entsprechend verbessert werden. Mit Vorteil ist das Isolationsrohr aus übereinander stapelbaren Modulen zusammensetzbar ausgestaltet, wobei die Module mindestens eine Generatorstufe und vorzugsweise zwei, drei oder vier Generatorstufen umfassen. Die modulare Bauweise ermöglicht eine effiziente Vorfertigung im Werk sowie eine schnelle und einfache Endmontage beim Kunden. Der Impulsgenerator kann zeitsparend und flexibel durch Hinzufügen oder Wegnehmen von Modulen an verschiedene gewünschte Hochspannungs- oder Hochstromwerte angepasst werden. Die Modularität ist also auch im Betrieb für den Anwender von grossem Nutzen.

In einem weiteren Ausführungsbeispiel ist der Kamin aus Isolierplatten aufgebaut, die zu einer dreieckigen Zylinderkonstruktion zusammengefügt sind, und es weist je eine Seitenwand der Dreieckszylinderkonstruktion Befestigungsöffnungen zur Montage der Schaltfunkenstrecke, eines Stosskondensators und zweier Anschlussarme zum Aufstecken eines Seriewiderstands und Parallelwiderstands auf. Die dreieckige Zylinderkonstruktion zeichnet sich durch einfachste Herstellbarkeit, mechanische Stabilität, Kompaktheit und eine sehr kleine umschlossene Induktionsfläche des Zündstromkreises aus.

Weitere Ausführungen, Vorteile und Anwendungen der Erfindung ergeben sich aus den abhängigen Ansprüchen sowie aus der nun folgenden Beschreibung anhand der Figuren.

### KURZE BESCHREIBUNG DER ZEICHNUNGEN

- Fig. 1: zeigt eine erfindungsgemässe tragende Kaminstruktur für einen Impulgenerator im Querschnitt; und
- Fig. 2: zeigt die Kaminstruktur gemäss Fig. 1 in einer Seitenansicht.

In den Figuren sind gleiche Teile mit gleichen Bezugszeichen versehen.

### WEGE ZUR AUSFÜHRUNG DER ERFINDUNG

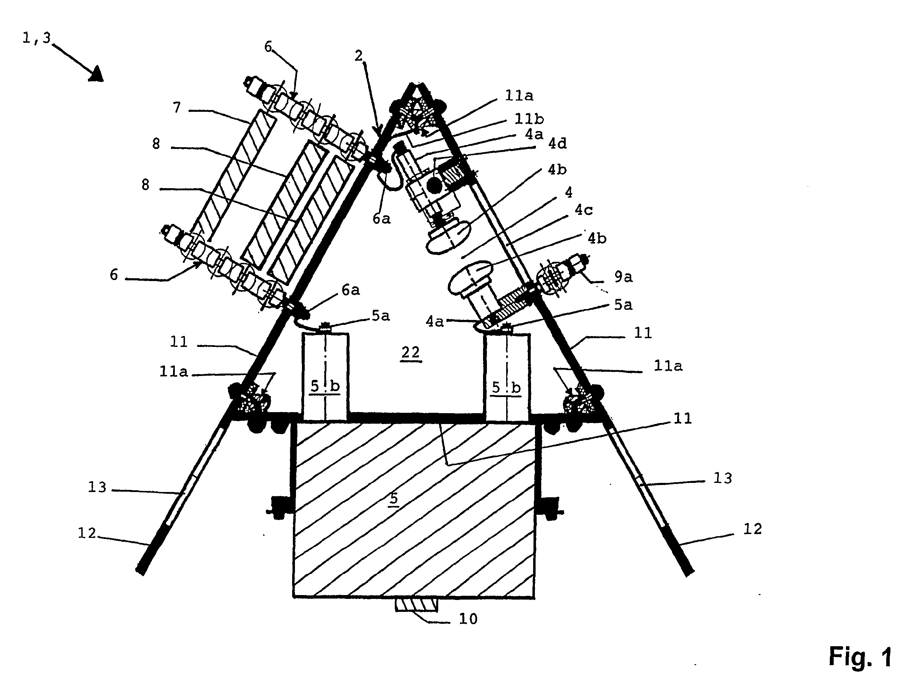

Fig. 1 zeigt einen Querschnitt durch eine Generatorstufe 3 eines elektrischen Impulsgenerators 1 und insbesondere eines Marx'scher Impulsspannungsgenerators 1 zur Erzeugung impulsförmiger Hochspannungen. In der dargestellten Generatorstufe 3 sind eine Schaltfunkenstrecke 4, ein Stosskondensator 5 und Anschlussarme 6 zum Einklinken mindestens eines Parallelwiderstands 8 in der Generatorstufe 3 und mindestens eines Seriewiderstands 7 zwischen zwei übereinander angeordneten Generatorstufen 3 dargestellt. Die Schaltfunkenstrecke 4 weist zwei typischerweise abgerundete Durchschlagselektroden 4b auf. Die allgemein bekannte Funktionsweise beruht darauf, dass in mehreren Generatorstufen 3 mindestens je ein Stosskondensator 5 parallel über Ladewiderstände 9 aufgeladen wird und über die Seriewiderstände 7 und Parallelwiderstände 8 in einer Serieschaltung impulsartig entladen werden. Auf an sich bekannte Weise dienen die Seriewiderstände 7, auch Front-, Stirn- oder Dämpfungswiderstände 7 genannt, zur Dimensionierung der Impulsanstiegszeiten und die Parallelwiderstände 8 zur Dimensionierung der Impulsabfallszeiten. Potentialwiderstände 9 können zur gleichmässigeren Spannungsverteilung und/oder sicheren Beseitigung von Restladungen der Gehäuse der Stosskondensatoren 5 vorhanden sein. Der Stosskondensator 4 weist Durchführungen 5b für seine Hochspannungsanschlüsse 5a auf, die typischerweise für 100 kV oder 200 kV pro Generatorstufe 3 ausgelegt sind. Die Anschlüsse 5a sind über möglichst kurze Kabelverbindungen o. ä. mit den Anschlüssen 4a der Schaltfunkenstrecke 4 und der Tragarme 6 für die Widerstände 7, 8 hochspannungsmässig verbunden. Die Seitenwände 11 bilden ein Traggerüst 2 für die Schaltfunkenstrecke 4 und die elektrischen Komponenten 5-10 der Generatorstufe 3. Darüberhinaus bilden die Seitenwände 11 einen seitlich umschlossenen Raum 22, der als Kamin 2 zum Luftaustausch für die im Kamin 2 innenliegende Schaltfunkenstrecke 4 dient. Durch den Kamin 2 kann Luft, getrocknete Luft oder ein anderes Fluid, z. B. ein Schutzgas, geleitet werden, um die Durchschlagsfestigkeit der Schaltfunkenstrecke 4 konstant zu halten oder gegenüber der Umgebungsluft zu erhöhen. Insbesondere werden durch den Kamin 2 Luftschwebeteilchen, Staub, Abbrand oder Ozon von vorherigen Entladungsvorgängen aus den Bereichen der Schaltfunkenstrecken 4 weggespült. Der erfindungsgemässe Kamin 2 vereinigt also in sich sowohl die Funktion eines kontrollierten Luftaustausches als auch eine tragende Funktion für elektrische Komponenten 5-10.

Im Ausführungsbeispiel gemäss Fig. 1 ist eine besonders kompakte Bauweise durch eine dreieckige zylindrische Kamin-Tragkonstruktion 2 realisiert. Die Dreiecksform 2 entspricht einer nahen oder sogar minimalen Beabstandung der Schaltfunkenstrecke 4, eines Stosskondensators 5 und der Widerstände 7, 8, wobei die flachen Seitenwände 11 besonders für eine einfache Montage der elektrischen Komponenten 5-9 geeignet ist. Andere polygonale Kaminquerschnitte 2 sind ebenfalls möglich und z. B. bei Vorhandensein mehrere Stosskondensatoren 5 pro Generatorstufe 3 oder zusätzlicher Hilfsfunkenstrecken (nicht dargestellt) gegebenenfalls sinnvoll. Mit Vorteil sind in jeder Generatorstufe 3 ein Stosskondensator 5, ein Seriewiderstand 7, ein Parallelwiderstand 8 und/oder ein Ladewiderstand 9 ausserhalb des Kamins 2 angeordnet und weisen Kontakte oder Durchführungen 5b in den Kamininneneraum 22 auf. Dadurch sind die elektrischen Komponenten 5-9 und besonders die Widerstände 7-9 sehr leicht von aussen auswechselbar und sichtbar. Insbesondere ist der Widerstandswert aufgrund eines charakteristischen Farbanstrichs kontrollierbar. Ein Antrieb 4d für die Justierung der Schaltfunkenstrecken 4 kann im Kamin 2 angeordnet sein. Der Kamin 2 kann mit Sichtfenstern 4c auf die Schaltfunkenstrecken 4 ausgerüstet sein, die auf an sich bekannte Weise zur Sichtkontrolle und gegebenenfalls für eine optische Vorionisation und damit leichtere Zündbarkeit der Luft in der Schaltfunkenstrecke 4 dienen. Durch die angegebene Dreieckszylinderkonstruktion 2 kann ein Stosswellen- oder Zündstromschaltkreis mit sehr geringer Querschnittsfläche oder umschlossener Fläche 22 und daher niedriger Selbstinduktion geschaffen werden.

Durch die integrierte Kamin-Tragkonstruktion 2 mit einem innenliegenden Kaminraum 22 wird eine sehr stabile, kompakte, einfach herstellbare und einfach handhabbare Tragkonstruktion 2 für mehrere oder sämtliche Generatorstufen 3 eines Impulsgenerators 1 geschaffen. Der Impulsgenerator 1 kann auch ein ähnlich aufgebauter Impulstromgenerator 1 sein. Herkömmliche Tragkonstruktionen mit Stützrohren und Stahlrahmen oder Zwischenverbindungsplatten zur seitlichen Halterung der Stützrohre können somit vereinfacht werden oder, wie dargestellt, gänzlich entfallen. Die Kamin-Tragkonsturktion 2 kann gegebenenfalls zusätzlich durch seitliche Abspannungen mit Glasfaserkabeln o. ä. seitlich stabilisiert werden.

Im angegebenen Ausführungsbeispiel ist die dreieckige Zylinderkonstruktion 2, d. h. das Rohr oder der Hohlzylinder 2 mit dreieckigem Querschnitt, aus die Seitenwände 11 bildenden Isolierplatten aufgebaut, die Befestigungsöffnungen zur Montage der elektrischen Komponenten 4-9 aufweisen. Die Isolierplatten 11 sind durch metallische Winkelelemente 11a zusammengefügt, die mit benachbarten Anschlüssen 4a, 5a, 6a der elektrischen Komponenten 4-9 über Leitungen 11b o. ä. kontaktiert sind. Zwei Seitenwände 11 der dreieckigen Zylinderkonstruktion 2 weisen im Bereich des Stosskondensators 5 überstehende Teile 12 mit mindestens je einem Tragloch 13 auf. Insbesondere verläuft eine Verbindungslinie durch die Traglöcher 13 im wesentlichen durch einen Schwerpunkt des Impulsgenerators 1, so dass der Impulsgenerator 1 oder ein einzelnes Generator-Modul 14 durch ein in die Traglöcher eingreifendes Hebewerkzeug sehr einfach und ohne seitliche Kippbewegung angehoben und transportiert werden kann.

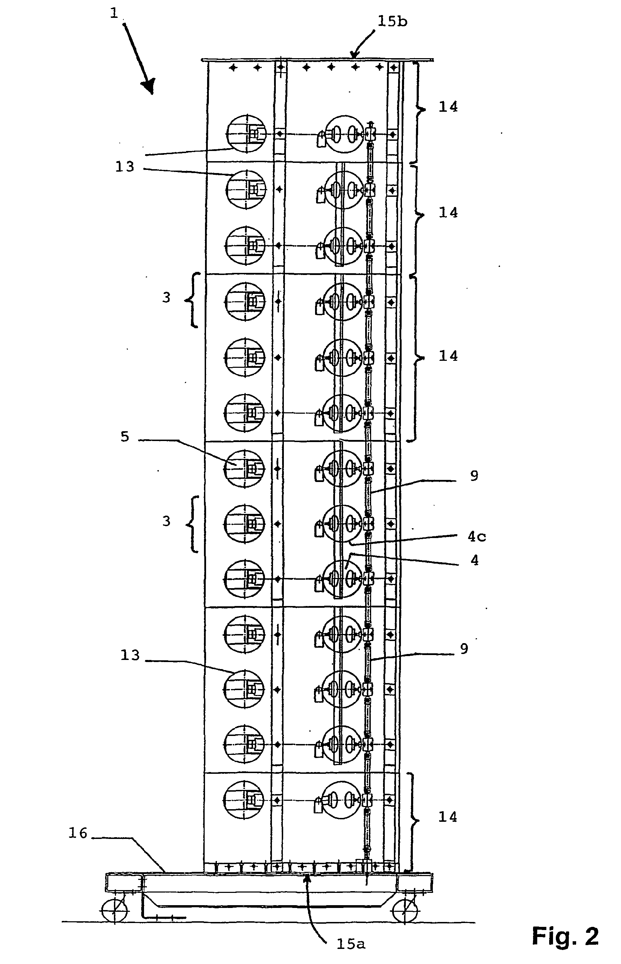

Fig. 2 zeigt die Kamin-Tragkonstruktion 2 in einer Seitenansicht. Das dreieckige, polygonale oder runde Isolationsrohr 11 ist hier aus übereinander stapelbaren Modulen 14 zusammensetzbar dargestellt. Beispielsweise im Falle dreieckiger Zylinder-Module 14 kann eine Aufsteckbarkeit dadurch realisiert sein, dass die Zylinder-Module 14 hervorstehende, zu einer Seitenwand 11 versetzt angeordnete Zentrierelemente (nicht dargestellt), insbesondere angeklebte oder an den Winkelelementen 11a montierte Zentriernasen, aufweisen. Im allgemeinen kann auch ein Zentrierrahmen zum Aufstecken der Zylinder-Module 14 vorhanden sein. Jedes. Modul 14 umfasst mindestens eine Generatorstufe 3 und vorzugsweise zwei, drei oder vier Generatorstufen 3. Zylinder-Module 14 können auch bei beliebigen anderen Kaminquerschnittsformen vorhanden sein. Das unterste Modul 14 soll eine Lufteintrittsöffnung 15a mit einem Gebläse und das oberste Modul 14 eine Luftaustrittsöffnung 15b aufweisen. Der Lufteintritt und Luftaustritt können auch vertauscht angeordnet sein. Das Traggerüst und der Kamin 2, insbesondere ein das Traggerüst bildender Kamin 2, kann oder können auf einem fahrbaren Gestell 16, z. B. auf einem Rollen- oder Luftkissen-Fahrzeug, montiert sein.

## Patentansprüche

1. Elektrischer Impulsgenerator (1), insbesondere geeignet zur Erzeugung hoher Impulsspannungen oder Impulsströme, umfassend einen Kamin (2) bildende Tragkonstruktion für mindestens eine aufladbare Generatorstufe (3), die eine Schaltfunkenstrecke (4) zur Erzeugung elektrischer Durchschläge in einem gasförmigen Medium und weitere elektrische Komponenten (5-10) zum Aufladen und/oder Entladen der Generatorstufe (3) aufweist, wobei die Schaltfunkenstrecke (4) im Kamin (2) mit einem vorgebbaren Gasaustausch zur Regulierung und/oder Konstanthaltung einer Durchschlagsfestigkeit des gasförmigen Mediums angeordnet ist, wobei die Tragkonstruktion (2) eine tragende Funktion für die Schaltfunkenstrecke (4) und für mindestens eine der elektrischen Komponenten (5-10) der mindestens einen aufladbaren Generatorstufe (3) hat, wobei der Kamin (2) ein Isolationsrohr (2) mit einem polygonalen oder runden Querschnitt ist und an den Seitenwänden (11) des Isolationsrohrs (2) für jede Generatorstufe (3) ein Stosskondensator (5), ein Seriewiderstand (7) und/oder ein Parallelwiderstand (8), befestigt sind, wobei der Stosskondensator (5), der Seriewiderstand (7), der Parallelwiderstand (8) und der Ladewiderstand (9) ausserhalb des Kamins (2) angeordnet sind und Kontakte oder Durchführungen (5b) in einen Kamininnenraum (22) vorgesehen sind.

2. Elektrischer Impulsgenerator (1) nach Anspruch 1, **dadurch gekennzeichnet, dass**
a) der Kamin (2) eine tragende Funktion für mindestens einen Stosskondensator (5) der mindestens einen aufladbaren Generatorstufe (3) hat und/oder
b) der Kamin (2) eine tragende Funktion für mindestens einen Seriewiderstand (7), Parallelwiderstand (8), Ladewiderstand (9) und/oder Potentialwiderstand (10) der mindestens einen aufladbaren Generatorstufe (3) hat und
c) insbesondere dass der Kamin (2) die Tragkonstruktion für alle Generatorstufen (3) des Impulsgenerators (1) bildet.

3. Elektrischer Impulsgenerator (1) nach einem der vorangehenden Ansprüche, **dadurch gekennzeichnet, dass**
a) das Isolationsrohr (2) eine kleine Querschnittsfläche zur Schaffung eines niederinduktiven Zündstromkreises mit einer kleinen umschlossene Fläche aufweist und/oder
b) das Isolationsrohr (2) aus übereinander stapelbaren Modulen (14) zusammensetzbar ausgestaltet ist, die mindestens eine Generatorstufe (3), vorzugsweise zwei, drei oder vier Generatorstufen (3), umfassen.

4. Elektrischer Impulsgenerator (1) nach einem der vorangehenden Ansprüche, **dadurch gekennzeichnet, dass** im Kamin (2) innenliegend Anschlüsse (4a, 5a, 6a) der Schaltfunkenstrecke (4), des Stosskondensators (5), des Seriewiderstands (7) und des Parallelwiderstands (8) angeordnet sind.

5. Elektrischer Impulsgenerator (1) nach einem der vorangehenden Ansprüche, **dadurch gekennzeichnet, dass**
a) der Kamin (2) aus Isolierplatten (11) aufgebaut ist, die zu einer dreieckigen Zylinderkonstruktion (2) zusammengefügt sind und
b) je eine Seitenwand (11) Befestigungsöffnungen zur Montage der Schaltfunkenstrecke (4), eines Stosskondensators (5) und zweier Anschlussarme (6) zum Aufstecken eines Seriewiderstands (7) und Parallelwiderstands (8) aufweisen.

6. Elektrischer Impulsgenerator (1) nach einem der vorangehenden Ansprüche, **dadurch gekennzeichnet, dass**
a) die Isolierplatten (11) durch metallische Winkelelemente (11a) zusammengefügt sind, die mit benachbarten Anschlüssen (4a, 5a, 6a) der Schaltfunkenstrecke (4) und der elektrischen Komponenten (5-9) kontaktiert sind und/oder
b) die dreieckige Zylinderkonstruktion (2) aus dreieckigen Zylinder-Modulen (14) zusammensetzbar ausgestaltet ist, die mindestens eine Generatorstufe (3), vorzugsweise zwei, drei oder vier Generatorstufen (3), tragen und aufeinander aufsteckbar sind,
c) insbesondere dass jedes Zylinder-Modul (14) hervorstehende, zu einer Seitenwand (11) versetzt angeordnete Zentrierelemente, insbesondere angeklebte oder an den Winkelelementen (11a) montierte Zentriernasen, oder einen Zentrierrahmen zum Aufstecken der Zylinder-Module (14) aufweist.

7. Elektrischer Impulsgenerator (1) nach einem der vorangehenden Ansprüche, **dadurch gekennzeichnet, dass**
a) zwei Seitenwände (11) der dreieckigen Zylinderkonstruktion (2) im Bereich eines Stosskondensators (5) überstehende Teile (12) mit mindestens je einem Tragloch (13) aufweisen und
b) insbesondere dass eine Verbindungslinie durch die Traglöcher (13) im wesentlichen durch einen Schwerpunkt des Impulsgenerators (1) verläuft.

8. Elektrischer Impulsgenerator (1) nach einem der vorangehenden Ansprüche, **dadurch gekennzeichnet, dass**
a) der Kamin (2) Sichtfenster (4c) auf die Schaltfunkenstrecken (4) aufweist und/oder
b) ein Antrieb (4d) für die Schaltfunkenstrecke (4) im Kamin (2) angeordnet ist und/oder
c) gegebenenfalls weitere Funkenstrecken ebenfalls im Kamin (2) angeordnet sind.

9. Elektrischer Impulsgenerator (1) nach einem der vorangehenden Ansprüche, **dadurch gekennzeichnet, dass**
a) der Kamin (2) an einem Ende, vorzugsweise am unteren Ende, eine Lufteintrittsöffnung (15a) mit einem Gebläse und an einem anderen Ende, vorzugsweise am oberen Ende, eine Luftaustrittsöffnung (15b) aufweist und/oder
b) die Tragkonstruktion und der Kamin (2), insbesondere eine Tragkonstruktion bildender Kamin (2), auf einem fahrbaren Gestell (16), insbesondere auf einem Rollen- oder Luftkissen-Fahrzeug, montiert ist oder sind und/oder
c) der Impulsgenerator (1) ein Marx'scher Impulsspannungsgenerator (1) oder ein Impulsstromgenerator ist.

## Claims

1. Electrical impulse generator (1), in particular suited for generating high impulse voltages or impulse currents, comprising a flue (2) formed by a support structure for at least one chargeable generator stage (3), which comprises a switching spark gap (4) for generating electrical discharges in a gaseous medium and further electrical components (5 - 10) for charging and/or discharging the generator stage (3), wherein the switching spark gap (4) is arranged in the flue (2) with a defined gas exchange for controlling and/or keeping constant a dielectric strength of the gaseous medium, wherein the support structure (2) has a supporting function for the switching spark gap (4) and for at least one of the electrical components (5 - 10) of the at least one chargeable generator stage (3), wherein the flue (2) is an insulating tube (2) with a polygonal or round cross section and an impulse capacitor (5), a series resistor (7) and/or a parallel resistor (8) are arranged for each generator stage (3) at the side walls (11) of the insulating tube (2), wherein the impulse capacitor (5), the series resistor (7), the parallel resistor (8) and the charge resistor (9) are arranged outside the flue (2) and contacts or lead-throughs (5b) into an interior (22) of the flue are provided.

2. Electrical impulse generator (1) of claim 1,
**characterized in that**
a) the flue (2) has a supporting function for at least one impulse capacitor (5) of the at least one chargeable generator stage (3) and/or
b) the flue (2) has a supporting function for at least one series resistor (7), parallel resistor (8), charge resistor (9) and/or potential resistor (10) of the at least one chargeable generator stage (3) and
c) in particular that the flue (2) forms the supporting frame for all generator stages (3) of the impulse generator (1).

3. Electrical pulse generator (1) of any of the preceding claims, **characterized in that**
a) the insulating tube (2) has a small cross section area for creating a low inductance spark current circuit with a small enclosed area and/or
b) the insulating tube (2) is designed to be assembled from modules (14) stackable on top of each other, which comprise at least one generator stage (3), preferably two, three or four generator stages (3).

4. Electrical impulse generator (1) of any of the preceding claims, **characterized in that** terminals (4a, 5a, 6a) of the switching spark gap (4), the impulse capacitor (5), the series resistor (7) and the parallel resistor (8) are arranged inside the flue (2).

5. Electrical impulse generator (1) of any of the preceding claims **characterized in that**
a) the flue (2) is built from insulating plates (11) assembled into a triangular cylinder assembly (2) and
b) mounting holes for mounting the switching spark gap (4), an impulse capacitor (5) and two mounting arms (6) for receiving a series resistor (7) and a parallel resistor (8) are provided in each side wall (11).

6. Electrical impulse generator (1) of one of the preceding claims **characterized in that**
a) the insulating plates (11) are linked by metallic bracket members (11a) contacting adjacent terminals (4a, 5a, 6a) of the switching spark gap (4) and the electrical components (5 - 9), and/or
b) the triangular cylinder assembly (2) can be assembled from triangular cylinder modules (14), which carry at least one generator stage (3), preferably two, three or four generator stages (3) and are stackable on top of each other,
c) in particular that each cylinder module (14) comprises projecting centering members in staggered relation to a side wall (11), in particular centering lugs adhered or mounted to the bracket members (11a), or a centering frame for attaching the cylinder modules (14).

7. Electrical impulse generator (1) of any of the preceding claims **characterized in that**
a) two side walls (11) of the triangular cylinder assembly (2) comprise projecting parts (12), each having at least one support hole (13), in an area of an impulse capacitor (5) and
b) in particular that a connecting line through the support holes (13) runs substantially through a center of gravity of the impulse generator (1).

8. Electrical impulse generator (1) of any of the preceding claims **characterized in that**
a) the flue (2) comprises viewing windows (4c) onto the switching spark gaps (4) and/or
b) a drive (4d) for the switching spark gap (4) is arranged in the flue (2) and/or
c) where applicable, further switching spark gaps are also arranged in the flue (2).

9. Electrical impulse generator (1) of any of the preceding claims **characterized in that**
a) the flue (2) comprises at one end, preferably at a lower end, an air input opening (15a) with a ventilator and at the other end, preferably at the upper end, an air outlet opening (15b) and/or
b) the support structure and the flue (2), in particular a flue (2) forming a support structure, are arranged on a mobile frame (16), in particular on a wheeled vehicle or air-cushioned vehicle, and/or
c) the impulse generator (1) is a Marx impulse voltage generator (1) or an impulse current generator.

## Revendications

1. Générateur d'impulsions électriques (1), en particulier approprié pour générer des tensions d'impulsion élevées ou des courants d'impulsion élevés, comprenant une construction porteuse formant une cheminée (2) pour au moins un niveau de générateur (3) rechargeable, qui présente un éclateur de commutation (4) pour générer des décharges disruptives électriques dans un milieu gazeux et autres composants (5-10) électriques pour le rechargement et/ou le déchargement du niveau de générateur (3), l'éclateur de commutation (4) étant disposé dans la cheminée (2) avec un échange de gaz prédéfinissable pour la régulation et/ou le maintien à un niveau constant d'une résistance disruptive du milieu gazeux, la construction porteuse (2) ayant une fonction porteuse pour l'éclateur de commutation (4) et pour au moins l'un des composants (5-10) électriques du au moins un niveau de générateur (3) rechargeable, la cheminée (2) étant un tuyau d'isolation (2) avec une section polygonale ou ronde et un condensateur de choc (5), une résistance de série (7) et/ou une résistance parallèle (8) étant fixés sur les parois latérales (11) du tuyau d'isolation (2) pour chaque niveau de générateur (3), le condensateur de choc (5), la résistance de série (7), la résistance parallèle (8) et la résistance de charge (9) étant disposés à l'extérieur de la cheminée (2) et des contacts ou des passages (5b) étant prévus dans un espace intérieur de cheminée (22).

2. Générateur d'impulsions électriques (1) selon la revendication 1, **caractérisé en ce que**
a) la cheminée (2) a une fonction portante pour au moins un condensateur de choc (5) du au moins un niveau de générateur (3) rechargeable et/ou
b) la cheminée (2) a une fonction portante pour au moins une résistance de série (7), une résistance parallèle (8), une résistance de charge (9) et/ou une résistance de potentiel (10) du au moins un niveau de générateur (3) rechargeable et
c) en particulier **en ce que** la cheminée (2) forme la construction porteuse pour tous les niveaux de générateur (3) du générateur d'impulsions (1).

3. Générateur d'impulsions électriques (1) selon l'une quelconque des revendications précédentes, **caractérisé en ce que**
a) le tuyau d'isolation (2) présente une petite surface de section pour créer un circuit d'allumage faiblement inductif avec une petite surface fermée et/ou
b) le tuyau d'isolation (2) à base de modules (14) empilables les uns sur les autres est conçu démontable, qui comprennent au moins un niveau de générateur (3) de préférence deux, trois ou quatre niveaux de générateur (3).

4. Générateur d'impulsions électriques (1) selon l'une quelconque des revendications précédentes, **caractérisé en ce que** des branchements (4a, 5a, 6a) de l'éclateur de commutation (4), du condensateur de choc (5), de la résistance de série (7) et de la résistance parallèle (8) sont disposés à l'intérieur dans la cheminée (2).

5. Générateur d'impulsions électriques (1) selon l'une quelconque des revendications précédentes, **caractérisé en ce que**
a) la cheminée (2) est montée à base de plaques isolantes (11), qui sont assemblées pour former une construction cylindrique (2) triangulaire et
b) à chaque fois une paroi latérale (11) présente des ouvertures de fixation pour le montage de l'éclateur de commutation (4), d'un condensateur de choc (5) et de deux bras de raccordement (6) pour l'emboîtement d'une résistance de série (7) et d'une résistance parallèle (8).

6. Générateur d'impulsions électriques (1) selon l'une quelconque des revendications précédentes, **caractérisé en ce que**
a) les plaques isolantes (11) sont assemblées par des éléments d'angle (11a) métalliques, qui sont mis en contact avec des branchements (4a, 5a, 6a) voisins de l'éclateur de commutation (4) et des composants (5-9) électriques et/ou
b) la construction cylindrique (2) triangulaire à base de modules cylindriques (14) triangulaires est conçue démontable, qui portent au moins un niveau de générateur (3), de préférence deux, trois ou quatre niveaux de générateur (3), et peuvent être emboîtés les uns sur les autres,
c) en particulier **en ce que** chaque module cylindrique (14) présente des éléments de centrage saillants, disposés de façon décalée par rapport à une paroi latérale (11), en particulier des ergots de centrage collés ou montés sur les éléments d'angle (11a) ou un cadre de centrage pour l'emboîtement des modules cylindriques (14).

7. Générateur d'impulsions électriques (1) selon l'une quelconque des revendications précédentes, **caractérisé en ce que**
a) deux parois latérales (11) de la construction cylindrique (2) triangulaire présentent dans la zone d'un condensateur de choc (5) des parties (12) saillantes comprenant chacune au moins un trou porteur (13) et
b) en particulier **en ce qu'**une ligne de liaison passant par les trous porteurs (13) passe principalement par un centre de gravité du générateur d'impulsions (1).

8. Générateur d'impulsions électriques (1) selon l'une quelconque des revendications précédentes, **caractérisé en ce que**
a) la cheminée (2) présente des fenêtres d'inspection (4c) sur les éclateurs de commutation (4) et/ou
b) un entraînement (4d) pour l'éclateur de commutation (4) est disposé dans la cheminée (2) et/ou
c) éventuellement d'autres éclateurs sont disposés également dans la cheminée (2).

9. Générateur d'impulsions électriques (1) selon l'une quelconque des revendications précédentes, **caractérisé en ce que**
a) la cheminée (2) présente sur une extrémité, de préférence sur l'extrémité inférieure, une ouverture d'entrée d'air (15a) avec une soufflerie et sur une autre extrémité, de préférence sur l'extrémité supérieure, une ouverture de sortie d'air (15b) et/ou
b) la construction porteuse et la cheminée (2), en particulier la cheminée (2) formant une construction porteuse, est ou sont montée(s) sur un châssis (16) mobile, ou en particulier sur un véhicule à roulettes ou à coussin d'air et/ou
c) le générateur d'impulsions (1) est un générateur de tension d'impulsion de Marx (1) ou un générateur de courant d'impulsion.
